# EUROPÄISCHE PATENTSCHRIFT

(11) **EP 2 483 937 B1**
(45) Veröffentlichungstag und Bekanntmachung des Hinweises auf die Patenterteilung: **09.01.2019**
(21) Anmeldenummer: 10749639.0
(22) Anmeldetag: 31.08.2010
(51) Int. Cl.: H01L 33/48, H01L 25/075, H01L 25/16, H01L 33/62, H01L 33/54, H01L 33/00

(54) **OPTOELEKTRONISCHES BAUELEMENT**
OPTOELECTRONIC COMPONENT
COMPOSANT OPTOÉLECTRONIQUE

(30) Priorität: 30.09.2009 DE 102009047878; 03.11.2009 DE 102009051746
(43) Veröffentlichungstag der Anmeldung: 08.08.2012
(73) Patentinhaber: OSRAM Opto Semiconductors GmbH, 93055 Regensburg (DE)
(72) Erfinder: MÜLLER, Klaus, 93186 Pettendorf (DE); SPATH, Günter, 93047 Regensburg (DE); HERRMANN, Siegfried, 94362 Neukirchen (DE); GÜNTHER, Ewald, Karl, Michael, 93128 Regenstauf (DE); BRUNNER, Herbert, 93161 Sinzing (DE)
(74) Vertreter: Epping - Hermann - Fischer
(86) Internationale Anmeldenummer: PCT/EP2010/062733
(87) Internationale Veröffentlichungsnummer: WO 2011/039023

(56) Entgegenhaltungen:
- WO-A1-2006/054616
- WO-A1-2009/069671
- WO-A2-2009/077974
- US-A1- 2006 043 402
- US-A1- 2007 221 935
- US-A1- 2007 272 940
- US-A1- 2008 258 168

## Beschreibung

Es wird ein optoelektronisches Bauelement angegeben. Darüber hinaus wird ein optoelektronisches Bauteil mit einem solchen optoelektronischen Bauelement angegeben. Ferner wird zur Erläuterung des optoelektronischen Bauelements ein Verfahren zur Herstellung eines optoelektronischen Bauelements beschrieben.

Die Druckschrift DE 10 2007 022 947 A1 beschreibt einen optoelektronischen Halbleiterkörper.

Die Druckschriften US 2007/0272940 A1, US 2006/0043402 A1 und WO 2009/077974 A2 beschreiben Halbleiterchips, bei denen es sich um sogenannte Flip-Chips handelt.

Die Druckschriften WO 2009/069671 A1 und WO 2006/054616 A1 beschreiben optoelektronische Bauelemente mit einem Konversionselement.

Eine zu lösende Aufgabe besteht darin, ein optoelektronisches Bauelement anzugeben, dessen Größe besonders einfach skalierbar ist.

Die Erfindung betrifft ein, optoelektronisches Bauelement gemäß Anspruch 1.

Beim hier beschriebenen optoelektronischen Bauelement handelt es sich beispielsweise um eine Leuchtdiode oder um einen Strahlungsdetektor.

Gemäß zumindest einer Ausführungsform des optoelektronischen Bauelements umfasst das optoelektronische Bauelement einen Träger. Der Träger kann eine beliebige Form aufweisen und ist beispielsweise nach Art eines Quaders gestaltet. Der Träger ist hinreichend mechanisch stabil, um zumindest einen Halbleiterchip zu tragen und mechanisch zu stützen. Der Träger kann dazu beispielsweise als Vollkörper aus einem starren Material oder auch als Folie ausgebildet sein. Der Träger weist eine erste Hauptfläche auf, die sich beispielsweise entlang einer Haupterstreckungsrichtung des Trägers erstreckt.

Das optoelektronische Bauelement umfasst zumindest einen substratlosen optoelektronischen Halbleiterchip. "Substratlos" bedeutet dabei, dass der optoelektronische Halbleiterchip beispielsweise eine epitaktisch hergestellte Schichtenfolge umfasst, die im Betrieb zur Erzeugung oder Detektion von elektromagnetischer Strahlung vorgesehen ist. Von der epitaktisch hergestellten Schichtenfolge des Halbleiterchips ist ein Aufwachssubstrat entfernt. Auf diese Weise ist ein optoelektronischer Halbleiterchip realisiert, der frei von einem Aufwachssubstrat und damit substratlos ist. Er weist vorzugsweise eine Dicke von weniger als 20 µm auf, zum Beispiel eine Dicke zwischen einschließlich 2 µm und 6 µm. Beim substratlosen optoelektronischen Halbleiterchip kann es sich beispielsweise um einen Leuchtdiodenchip, einen Laserdiodenchip oder einen Fotodetektorchip handeln.

Das optoelektronische Bauelement umfasst eine Kontaktmetallisierung. Die Kontaktmetallisierung ist dazu vorgesehen, den zumindest einen optoelektronischen Halbleiterchip zu kontaktieren. Die Kontaktmetallisierung enthält oder besteht zum Beispiel aus zumindest einem der folgenden Metalle: Gold, Platin, Silber, Aluminium. Die Metalle zur Bildung der Kontaktmetallisierung werden beispielsweise mittels Aufdampfen auf zumindest Teile des Trägers aufgebracht und anschließend, zum Beispiel unter Verwendung photolithographischer Methoden, zu einer Kontaktmetallisierung strukturiert.

Der Träger ist elektrisch isolierend ausgebildet. Der Träger besteht dazu vorzugsweise aus einem elektrisch isolierenden oder elektrisch schlecht leitenden Material. Der Träger enthält zum Beispiel eines der folgenden Materialien oder besteht aus einem der folgenden Materialien: Keramik, Silizium, Kunststoff. Ist der Träger mit einem keramischen Material gebildet, so kann der Träger zum Beispiel Al2O3, AlN und / oder BN (zum Beispiel polykristallines kubisches Bornitrid, PCBN) enthalten oder aus einem dieser Materialien bestehen.

Der optoelektronische Halbleiterchip ist mittels eines Verbindungsmaterials an der ersten Hauptfläche des Trägers befestigt. Der optoelektronische Halbleiterchip ist dann mittels des Verbindungsmaterials auch elektrisch leitend mit der Kontaktmetallisierung des optoelektronischen Bauelements verbunden. Der optoelektronische Halbleiterchip kann beispielsweise mittels eines Lotmaterials, das zwischen dem optoelektronischen Halbleiterchip und der ersten Hauptfläche des Trägers angeordnet ist, mit dem Träger mechanisch verbunden. Mit anderen Worten kann der optoelektronische Halbleiterchip an der ersten Hauptfläche auf den Träger gelötet sein.

Die Kontaktmetallisierung bedeckt zumindest einen Bereich der ersten Hauptfläche des Trägers, der frei vom optoelektronischen Halbleiterchip ist. Das heißt, auf der ersten Hauptfläche des Trägers sind Stellen von der Kontaktmetallisierung bedeckt, die nicht vom optoelektronischen Halbleiterchip bedeckt sind. Mit anderen Worten weist der Träger zumindest in eine Richtung parallel zur ersten Hauptfläche, also in einer lateralen Richtung, eine größere Erstreckung als der oder die optoelektronischen Halbleiterchips auf, die an der ersten Hauptfläche auf dem Träger befestigt sind. Der Träger kann also in lateralen Richtungen eine andere, vorzugsweise eine größere Erstreckung als der Chip aufweisen. Mittels des Trägers ist damit die effektive Fläche des Chips vergrößert, was die Handhabung des optoelektronischen Halbleiterchips erleichtern kann. Die zusätzliche Fläche kann beispielsweise für die Kontaktmetallisierung genutzt werden, mit der der optoelektronische Halbleiterchip vorzugsweise elektrisch leitend verbunden ist. Die Kontaktmetallisierung kann dann zum externen elektrischen Anschließen des optoelektronischen Halbleiterchips dienen. Beispielsweise kann die Kontaktmetallisierung mit Bauelementanschlüssen oder äußeren Anschlussstellen des Bauelements elektrisch leitend verbunden sein.

Ein Beispiel eines optoelektronischen Bauelements umfasst einen Träger, der eine erste Hauptfläche aufweist, zumindest einen substratlosen optoelektronischen Halbleiterchip und eine Kontaktmetallisierung. Der Träger ist dabei elektrisch isolierend ausgebildet, der zumindest eine optoelektronische Halbleiterchip ist mittels eines Verbindungsmaterials, insbesondere eines Lotmaterials, an der ersten Hauptfläche des Trägers befestigt. Die Kontaktmetallisierung bedeckt zumindest einen Bereich der ersten Hauptfläche, der frei vom optoelektronischen Halbleiterchip ist und ist elektrisch leitend mit dem optoelektronischen Halbleiterchip verbunden.

Das hier beschriebene optoelektronische Bauelement weist dabei unter anderem die folgenden Vorteile auf: Über den Träger kann der substratlose optoelektronische Halbleiterchip thermisch besonders gut angebunden werden, da der Träger beispielsweise eine Fläche, an der eine thermische Anbindung erfolgt, vergrößert. Ferner kann der Träger selbst als Wärmesenke zur Aufnahme von der im Betrieb des Halbleiterchips erzeugten Wärme dienen. Mittels Ausgestaltung des Trägers ist es ferner möglich, dass die äußeren Abmessungen des optoelektronischen Bauelements relativ frei, das heißt in der maximalen Abmessung unabhängig von der Größe der verwendeten substratlosen optoelektronischen Halbleiterchips, gestaltet werden. Die Größe des optoelektronischen Bauelements ist also skalierbar. Über das Aufbringen von mehreren substratlosen optoelektronischen Halbleiterchips auf einem Träger kann ein optoelektronisches Bauelement geschaffen werden, das eine besonders große Strahlungsdurchtrittsfläche aufweist, durch die elektromagnetische Strahlung aus dem Bauelement austritt oder in dieses eintritt. Das optoelektronische Bauelement selbst kann wiederum nach Art eines herkömmlichen optoelektronischen Halbleiterchips beispielsweise in einem vorgefertigten Gehäusegrundkörper verbaut werden oder bildet selbst ein beispielsweise oberflächenmontierbares optoelektronisches Bauteil. Durch die Verwendung eines Trägers für den zumindest einen substratlosen optoelektronischen Halbleiterchip ist es ferner möglich, zusätzliche elektrische und elektronische Funktionen in das optoelektronische Bauelement durch Integration in den Träger zu integrieren. So kann der Träger beispielsweise Widerstandselemente, ESD-Schutzelemente oder Ansteuerschaltungen umfassen. Dabei ist es insbesondere auch möglich, dass der Träger selbst ein integrierter Schaltkreis zur Ansteuerung des zumindest einen substratlosen optoelektronischen Halbleiterchips ist. Beispielsweise handelt es sich beim Träger dann um einen CMOS-Chip, auf dem der zumindest eine substratlose optoelektronische Halbleiterchip befestigt und elektrisch angeschlossen ist. Der CMOS-Chip kann dann zur Ansteuerung des optoelektronischen Halbleiterchips Verwendung finden. Durch die Verwendung eines substratlosen optoelektronischen Halbleiterchips im optoelektronischen Bauelement ist es ferner möglich, ein besonders flaches optoelektronisches Bauelement zu schaffen, das aufgrund der Verwendung eines Trägers dennoch eine ausreichende mechanische Stabilität aufweist. Das hier beschriebene optoelektronische Bauelement kann nach Art eines herkömmlichen optoelektronischen Halbleiterchips in unterschiedlichen, bereits kommerziell erhältlichen Gehäusetypen Verwendung finden. Schließlich ist es mit dem hier beschriebenen optoelektronischen Bauelement möglich, gleichartige substratlose optoelektronische Halbleiterchips in ein und demselben Bauelement zu integrieren. Beispielsweise können als substratlose optoelektronische Halbleiterchips substratlose Leuchtdiodenchips Verwendung finden, die beispielsweise mit einer Toleranz von kleiner 2 nm im Betrieb elektromagnetische Strahlung mit der gleichen Peakwellenlänge erzeugen. Darüber hinaus strahlen die substratlosen Leuchtdiodenchips dann mit einer Toleranz von beispielsweise höchstens 10 % bei gleicher Bestromung elektromagnetische Strahlung gleicher Intensität ab. Mit anderen Worten können auf dem Träger also vorsortierte, gleichartige Halbleiterchips Verwendung finden. Dies ermöglicht optoelektronische Bauelemente mit beispielsweise besonders großer, homogen erscheinender Abstrahlfläche.

Gemäß zumindest einer Ausführungsform des optoelektronischen Bauelements bedecken zumindest zwei Kontaktmetallisierungen einen Bereich der ersten Hauptfläche, der frei vom optoelektronischen Halbleiterchip ist. Zumindest eine der Kontaktmetallisierungen dient dann zum n-seitigen Anschluss des optoelektronischen Halbleiterchips, eine andere der Kontaktmetallisierungen dient dann zum p-seitigen Anschluss des optoelektronischen Halbleiterchips.

Gemäß zumindest einer Ausführungsform des optoelektronischen Bauelements weist dieses ein reflektierendes Vergussmaterial auf. Reflektierend bedeutet, dass das Vergussmaterial für Strahlung im sichtbaren Spektralbereich eine Reflektivität von insbesondere mehr als 80 % oder von mehr als 90 %, bevorzugt von mehr als 94 % aufweist. Das Vergussmaterial reflektiert bevorzugt diffus. Für einen Betrachter erscheint das Vergussmaterial bevorzugt weiß.

Gemäß zumindest einer Ausführungsform des optoelektronischen Bauelements umgibt das reflektierende Vergussmaterial den optoelektronischen Halbleiterchip in einer lateralen Richtung ringsum. Insbesondere steht das Vergussmaterial ringsum zumindest stellenweise in unmittelbarem Kontakt zu dem optoelektronischen Halbleiterchip. Zum Beispiel bedeckt das reflektierende Vergussmaterial die erste Hauptfläche des Trägers vollständig, wobei lediglich die dem Träger abgewandte Oberseite des optoelektronischen Halbleiterchips frei vom reflektierenden Vergussmaterial ist. Das reflektierende Vergussmaterial bedeckt dabei vorzugsweise auch die Kontaktmetallisierung vollständig, so dass diese in Draufsicht auf den Träger nicht erkennbar ist.

Bei dem reflektierenden Vergussmaterial handelt es sich bevorzugt um ein Polymer, in das reflektierend wirkende Partikel eingefüllt sind. Das Polymer des Vergussmaterials, das eine Matrix für die Partikel bildet, ist zum Beispiel ein Silikon, ein Epoxid oder ein Silikon-Epoxid-Hybridmaterial. Die reflektierenden Partikel sind zum Beispiel aus einem Metalloxid wie Aluminiumoxid oder Titanoxid, aus einem Metallfluorid wie Calciumfluorid oder aus einem Siliziumoxid hergestellt oder bestehen daraus. Ein mittlerer Durchmesser der Partikel, beispielsweise ein Median-Durchmesser d₅₀ in Qo, liegt bevorzugt zwischen einschließlich 0,3 µm und 5 µm. Ein Gewichtsanteil der Partikel an dem gesamten Vergussmaterial beträgt bevorzugt zwischen einschließlich 5 % und 50 %, insbesondere zwischen einschließlich 10 % und 30 %. Die Partikel wirken reflektierend aufgrund ihrer bevorzugt weißen Farbe und/oder aufgrund ihres Brechungsindexunterschieds zu dem Matrixmaterial.

Der Träger weist zumindest eine Öffnung auf, die sich von der ersten Hauptfläche durch den Träger hindurch zu einer der ersten Hauptfläche gegenüberliegenden zweiten Hauptfläche erstreckt. Die Öffnung ist beispielsweise als Bohrung oder Durchbruch im Material des Trägers ausgebildet. Die Öffnung ist zumindest stellenweise mit einem elektrisch leitenden Material befüllt, das derart in die Öffnung eingebracht ist, dass sich ein elektrisch leitender Pfad mittels des elektrisch leitenden Materials durch die Öffnung hindurch von der zweiten Hauptfläche zur ersten Hauptfläche des Trägers erstreckt. Dazu kann die Öffnung an dem Träger zugewandten Innenflächen mit dem elektrisch leitenden Material beschichtet sein. Es ist jedoch auch denkbar, dass die gesamte Öffnung mit dem elektrisch leitenden Material ausgefüllt ist.

Das elektrisch leitende Material ist dabei mit der Kontaktmetallisierung des optoelektronischen Bauelements verbunden, so dass über das elektrisch leitende Material in der Öffnung eine elektrische Kontaktierung des zumindest einen substratlosen optoelektronischen Halbleiterchips erfolgen kann.

Gemäß zumindest einer Ausführungsform des optoelektronischen Bauelements ist zumindest eine der Öffnungen in lateraler Richtung, das heißt in Richtungen parallel zur ersten Hauptfläche des Trägers, vollständig vom Träger umgeben. Mit anderen Worten erstreckt sich die Öffnung innerhalb des Trägers und weist zumindest näherungsweise die Form eines dreidimensionalen Körpers wie eines Zylinders, eines Kegelstumpfes oder eines Quaders auf. Das elektrisch leitende Material in der Öffnung grenzt dann an den Träger. Auf diese Weise ist das elektrisch leitende Material in der Öffnung durch den Träger vor äußeren Einflüssen geschützt.

Das elektrisch leitende Material zumindest einer Öffnung ist in lateraler Richtung stellenweise frei vom Träger. In diesem Fall ist die Öffnung beispielsweise in lateraler Richtung nicht vollständig vom Träger umgeben, sondern nach außen hin offen. Die Öffnung weist dann beispielsweise die Form eines Halb- oder eines Viertelzylinders auf. Eine solche Öffnung kann beispielsweise durch ein Durchtrennen des Trägers durch die Öffnung hindurch erfolgen. Das optoelektronische Bauelement kann dann Durchkontaktierungen am Rand aufweisen, die mit einem Anschlussmaterial benetzbar sind. Auf diese Weise kann zum Beispiel bei der SMT-Montage des optoelektronischen Bauelements im Bereich der Öffnung ein Lotmeniskus ausgebildet werden.

Es ist dabei auch möglich, dass das optoelektronische Bauelement zumindest eine Öffnung aufweist, die in lateraler Richtung vollständig vom Träger umgeben ist und zumindest eine Öffnung, in der das elektrisch leitende Material in lateraler Richtung stellenweise zugänglich ist.

Gemäß zumindest einer Ausführungsform des optoelektronischen Bauelements ist an der zweiten Hauptfläche des Trägers zumindest ein Bauelementanschluss angeordnet. Der Bauelementanschluss ist elektrisch leitend mit dem elektrisch leitenden Material zumindest einer Öffnung verbunden. Über den Bauelementanschluss und das elektrisch leitende Material in der Öffnung kann dann die Kontaktmetallisierung und damit der optoelektronische Halbleiterchip elektrisch angeschlossen werden. Beispielsweise umfasst das optoelektronische Bauelement zumindest zwei Bauelementanschlüsse an der zweiten Hauptfläche des Trägers. Beim optoelektronischen Bauelement kann es sich dann um ein oberflächenmontierbares optoelektronisches Bauelement handeln, das ohne Verwendung eines zusätzlichen Bauteilgehäuses an sich schon ein optoelektronisches Bauteil wie beispielsweise eine Leuchtdiode darstellt.

Das optoelektronische Bauelement umfasst zumindest zwei gleichartige optoelektronische Halbleiterchips, die an der ersten Hauptfläche des Trägers befestigt sind. Bei den optoelektronischen Halbleiterchips, die gleichartig ausgebildet sind, handelt es sich um gleichartig ausgebildete Leuchtdioden, die innerhalb einer bestimmten Toleranz elektromagnetische Strahlung mit der gleichen Intensität und der gleichen Wellenlänge emittieren. Ferner weist das optoelektronische Bauelement zumindest ein Konversionselement auf, das die gleichartigen optoelektronischen Halbleiterchips an ihrer der ersten Hauptfläche abgewandten Seite überdeckt. Bei dem Konversionselement handelt es sich beispielsweise um einen Leuchtstoff, der in ein Matrixmaterial eingebracht ist. Ferner kann es sich bei dem Konversionselement um ein Plättchen handeln, das aus einem keramischen Leuchtstoff gebildet ist. Da die optoelektronischen Halbleiterchips gleichartig aufgebaut sind, kann ein einziges Konversionselement zum Überdecken der gleichartig aufgebauten optoelektronischen Halbleiterchips Verwendung finden. Das Mischlicht, das sich beispielsweise aus dem von den optoelektronischen Halbleiterchips abgestrahlten Licht und dem durch das Konversionselement wellenlängenkonvertierten Licht zusammensetzt, wird homogen abgestrahlt, ohne dass zwischen unterschiedlichen optoelektronischen Halbleiterchips Schwankungen im Farbort oder der Farbtemperatur oder der Intensität des abgestrahlten Mischlichts erkennbar sind.

Dabei ist es möglich, dass die reflektierende Vergussmasse Seitenflächen des Konversionselements bedeckt, so dass lediglich die dem optoelektronischen Halbleiterchip abgewandte Oberseite frei von der reflektierenden Vergussmasse ist. Die Vergussmasse kann dabei auch die erste Hauptfläche des Trägers stellenweise oder vollständig bedecken. Die verbleibende Außenfläche des Trägers kann frei von der Vergussmasse sein.

Gemäß zumindest einer Ausführungsform des optoelektronischen Bauelements überdeckt das Konversionselement dabei auch einen Zwischenraum zwischen zwei benachbarten gleichartigen optoelektronischen Halbleiterchips. Das Konversionselement kann in diesem Fall dazu Verwendung finden, dass die Zwischenräume zwischen zwei benachbarten gleichartigen optoelektronischen Halbleiterchips, die im Falle von strahlungsemittierenden Halbleiterchips als dunkel erscheinen, kaum oder gar nicht mehr als dunkle Stellen in der Strahlungsaustrittsfläche des optoelektronischen Bauelements zu erkennen sind.

Gemäß zumindest einer Ausführungsform des optoelektronischen Bauelements umfasst das Bauelement einen Vergusskörper, der den optoelektronischen Halbleiterchip zumindest stellenweise umformt, wobei der Vergusskörper an die erste Hauptfläche des Trägers grenzt,und zumindest eine Seitenfläche des Vergusskörpers bündig mit zumindest einer Seitenfläche des Trägers abschließt. Beispielsweise schließen alle Seitenflächen des Vergusskörpers bündig mit den zugeordneten Seitenflächen des Trägers ab. Das heißt, der Vergusskörper überragt den Träger nicht in lateraler Richtung und umgekehrt. Beispielsweise kann der Vergusskörper auf den Träger aufgebracht werden, solange dieser in einem Trägerverbund mit einer Vielzahl von Trägern vorliegt. Beim Vereinzeln des Trägerverbunds in einzelne Träger wird dann auch durch den Vergusskörper vereinzelt, so dass die Seitenflächen von Vergusskörper und Träger im gleichen Verfahrensschritt erzeugt werden. Der Vergusskörper weist dann an seinen Seitenflächen Vereinzelungsspuren, wie beispielsweise Sägerillen auf. Auch der Träger kann an seinen Seitenflächen dann Vereinzelungsspuren, wie beispielsweise Sägerillen aufweisen. Der Vergusskörper kann stellenweise beispielsweise nach Art einer Linse ausgeformt sein, so dass er zur Strahlformung der vom optoelektronischen Halbleiterchip im Betrieb elektromagnetischer Strahlung dienen kann. Beispielsweise ist der Vergusskörper mit einem Silikonmaterial, einem Epoxidmaterial oder einem Silikon-Epoxid-Hybridmaterial gebildet.

Es wird darüber hinaus ein optoelektronisches Bauteil angegeben. Das optoelektronische Bauteil umfasst einen Gehäusegrundkörper. Der Gehäusegrundkörper kann beispielsweise durch eine Leiterplatte gebildet sein oder eine Leiterplatte umfassen. Darüber hinaus ist es möglich, dass der Gehäusegrundkörper mit einem keramischen Material oder einem Kunststoffmaterial gebildet ist, in das eine Kavität zur Aufnahme eines optoelektronischen Bauelements eingebracht ist. In jedem Fall umfasst das optoelektronische Bauteil zumindest ein optoelektronisches Bauelement wie es in zumindest einer der oben genannten Ausführungsformen beschrieben ist. Das optoelektronische Bauelement ist dabei im oder am Gehäusegrundkörper befestigt. Beispielsweise kann das optoelektronische Bauelement zusätzlich elektrisch leitend mit Teilen des Gehäusegrundkörpers oder elektrischen Anschlussstellen, die im oder am Gehäusegrundkörper befestigt sind, elektrisch leitend verbunden sein.

Gemäß zumindest einer Ausführungsform des optoelektronischen Bauelements ist das optoelektronische Bauelement zumindest stellenweise von einem Vergusskörper umformt, wobei der Vergusskörper an den Träger, den optoelektronischen Halbleiterchip und den Gehäusegrundkörper grenzt. Beispielsweise ist das optoelektronische Bauelement in eine Kavität des Gehäusegrundkörpers eingebracht. Das optoelektronische Bauelement kann in dieser Kavität dann mit einem strahlungsdurchlässigen Vergussmaterial vergossen sein, welches den Vergusskörper bildet. Das heißt, das optoelektronische Bauelement mit dem Träger und dem zumindest einen optoelektronischen Halbleiterchip auf dem Träger wird nach Art eines herkömmlichen optoelektronischen Halbleiterchips in einem Gehäusegrundkörper befestigt und mit einem Vergusskörper vergossen. Auf diese Weise können bekannte und bereits kommerziell erhältliche Gehäusegrundkörper für das hier beschriebene optoelektronische Bauelement Verwendung finden.

Es wird ferner zur Erläuterung ein Verfahren zur Herstellung eines optoelektronischen Bauelements angegeben. Beispielsweise kann mittels des hier beschriebenen Verfahrens ein hier beschriebenes optoelektronisches Bauelement hergestellt werden. Das heißt, sämtliche für das optoelektronische Bauelement beschriebene Merkmale sind auch für das Verfahren offenbart und umgekehrt.

Gemäß zumindest einer Ausführungsform des Verfahrens umfasst das Verfahren einen Schritt, bei dem ein Trägerverbund mit einer Vielzahl von Trägern bereitgestellt wird. Beispielsweise handelt es sich bei dem Trägerverbund um eine große Scheibe aus dem Material, aus dem die Träger gebildet sind. Es kann sich zum Beispiel um eine große Scheibe aus einem keramischen Material, aus Silizium, aus Kunststoff oder um eine Folie handeln.

Gemäß zumindest einer Ausführungsform des Verfahrens wird ferner eine Vielzahl von optoelektronischen Halbleiterchips bereitgestellt, die auf einem Substrat angeordnet sind. Die Halbleiterchips können dabei auf dem Substrat als durchgehende aktive Schichtenfolge vorliegen, das heißt, sie sind noch nicht zu einzelnen Chips vereinzelt. Bei dem Substrat handelt es sich beispielsweise um das Aufwachssubstrat, auf das die optoelektronischen Halbleiterchips, das heißt die aktive Schichtenfolge, epitaktisch abgeschieden sind.

Gemäß zumindest einer Ausführungsform des Verfahrens werden die optoelektronischen Halbleiterchips vom Substrat abgelöst. Das Ablösen kann dabei vor oder nach einem Vereinzeln der aktiven Schichtenfolge zu einzelnen optoelektronischen Halbleiterchips erfolgen. Das heißt, beim Ablösen können die optoelektronischen Halbleiterchips noch in einem Verbund mit einer Vielzahl von optoelektronischen Halbleiterchips vorliegen. Das Ablösen kann beispielsweise mittels eines Laser-Lift-off-Verfahrens geschehen.

Gemäß zumindest einer Ausführungsform des Verfahrens wird zumindest einer der optoelektronischen Halbleiterchips auf zumindest einen der Träger des Trägerverbunds aufgebracht und befestigt. Dies kann beispielsweise mittels einer Lotmontage geschehen. Das heißt, zumindest ein optoelektronischer Halbleiterchip wird auf zumindest einen Träger des Trägerverbunds gelötet.

Gemäß zumindest einer Ausführungsform des Verfahrens wird vor dem Aufbringen des optoelektronischen Halbleiterchips auf dem Träger eine Funktionskontrolle unter Betreiben des optoelektronischen Halbleiterchips durchgeführt. Das heißt, der optoelektronische Halbleiterchip wird beispielsweise zur Erzeugung von elektromagnetischer Strahlung betrieben. Dabei kann die erzeugte elektromagnetische Strahlung vermessen werden. Ein nicht funktionierender optoelektronischer Halbleiterchip wird nicht auf einem Träger des Trägerverbunds befestigt, so dass kein Träger mit einem funktionsuntüchtigen Halbleiterchip belegt wird. Ferner können die optoelektronischen Halbleiterchips vorsortiert auf die Träger des Trägerverbunds aufgebracht werden. Das heißt, es können beispielsweise gleichartige optoelektronische Halbleiterchips auf benachbarte Träger des Trägerverbunds oder auf denselben Träger des Trägerverbunds aufgebracht werden. Es kann also vor der Fertigstellung des optoelektronischen Bauelements schon eine Vorsortierung der optoelektronischen Halbleiterchips erfolgen.

Gemäß zumindest einer Ausführungsform des Verfahrens werden die optoelektronischen Halbleiterchips vor dem Aufbringen auf einen Träger des Trägerverbunds auf einen Hilfsträger aufgebracht. Die Funktionskontrolle kann dann auf dem Hilfsträger durchgeführt werden. Die optoelektronischen Halbleiterchips werden dabei auf dem Hilfsträger vorzugsweise derart befestigt, dass sie zerstörungsfrei wieder vom Hilfsträger gelöst werden können. Nach dem Lösen vom Hilfsträger werden die optoelektronischen Halbleiterchips dann gegebenenfalls auf einem Träger des Trägerverbunds befestigt. Halbleiterchips, die nicht im Bereich vorgebbarer Parameter funktionieren, verbleiben auf dem Hilfsträger, so dass kein teures Trägermaterial verbraucht wird. Auf diese Weise wirkt sich die Ausbeute an funktionstüchtigen Halbleiterchips weniger stark auf die Kosten des Bauelements aus.

Nach dem Aufbringen von optoelektronischen Halbleiterchips auf die Träger des Trägerverbunds kann dieser in einzelne Bauelemente vereinzelt werden. Dies kann beispielsweise mit anderen Methoden erfolgen, als dies für das Vereinzeln von optoelektronischen Halbleiterchips der Fall ist, da das Vereinzeln der Halbleiterchips und das Vereinzeln des Trägerverbunds voneinander entkoppelt ist. Es können beispielsweise besonders effiziente Methoden zur Vereinzelung des Trägerverbunds wie "Stealth Dicing" oder "Dicing by Grinding" Verwendung finden, wodurch der Durchsatz bei der Produktion der optoelektronischen Halbleiterbauelement und/oder die Flächennutzung gesteigert ist.

Gemäß zumindest einer Ausführungsform des Verfahrens wird eine Metallisierung auf eine erste Hauptfläche zumindest eines Trägers des Trägerverbunds aufgebracht. Die Metallisierung kann dabei vor oder nach Aufbringen eines optoelektronischen Halbleiterchips auf den Träger aufgebracht werden. Ferner ist es möglich, dass ein Teil der Metallisierung vor Aufbringen des Halbleiterchips aufgebracht wird und ein anderer Teil der Metallisierung nach Aufbringen des Halbleiterchips. Die Metallisierung wird nach dem Aufbringen unter Verwendung eines fotolithographischen Verfahrens zu einer Kontaktmetallisierung strukturiert. Das heißt, es werden beispielsweise zwei elektrisch voneinander getrennte Bereiche der Metallisierung auf der ersten Hauptfläche des Trägers erzeugt, mittels derer der strahlungsemittierende Halbleiterchip n- und p-seitig kontaktiert werden kann.

Im Folgenden werden das hier beschriebene optoelektronische Bauelement, das hier beschriebene optoelektronische Bauteil sowie das hier beschriebene Verfahren zur Herstellung eines optoelektronischen Bauelements anhand von Ausführungsbeispielen und den dazugehörigen Figuren näher erläutert.

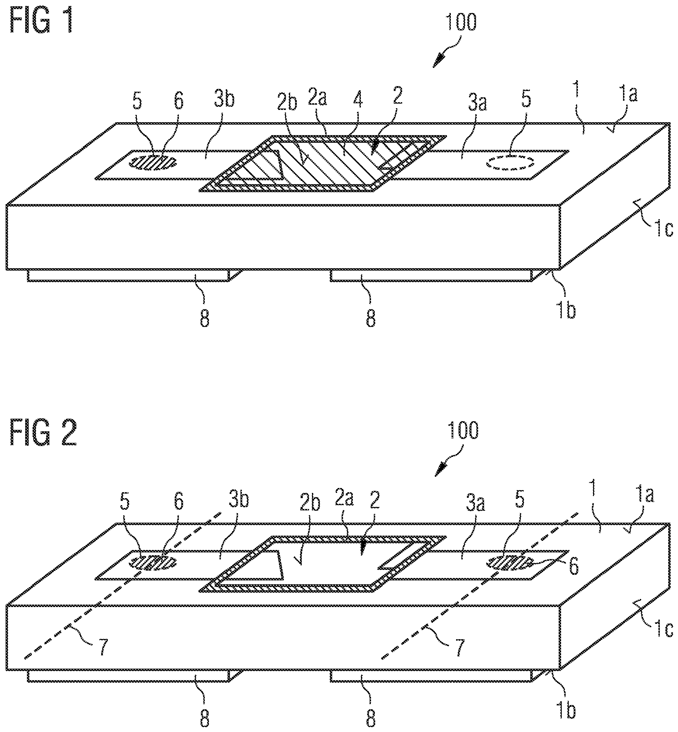

Anhand der schematischen Perspektivdarstellungen der Figuren 1, 2 und 3 sind Beispiele eines hier beschriebenen optoelektronischen Bauelements näher erläutert.

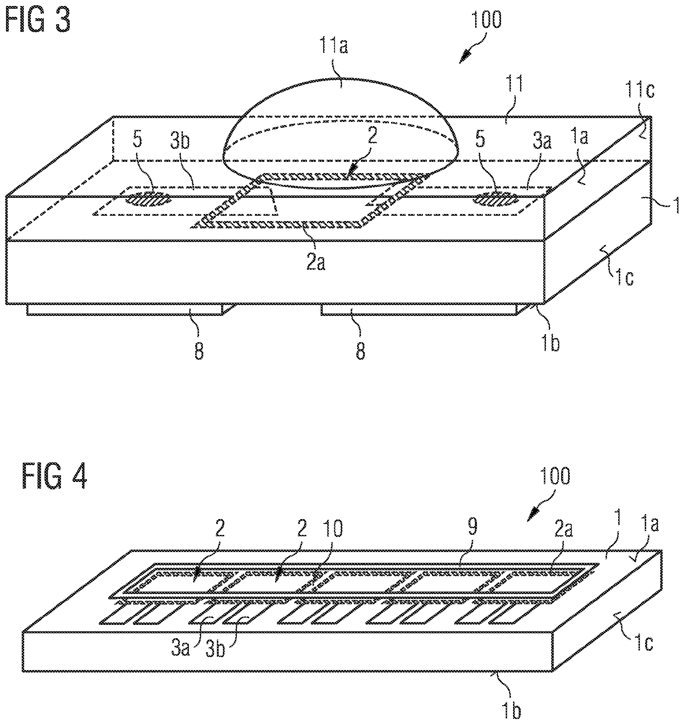

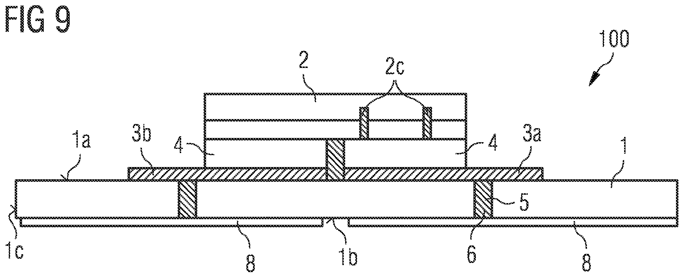

Anhand der schematischen Perspektivdarstellungen der Figuren 4 und 9 sind Ausführungsbeispiele eines hier beschriebenen optoelektronischen Bauelements näher erläutert.

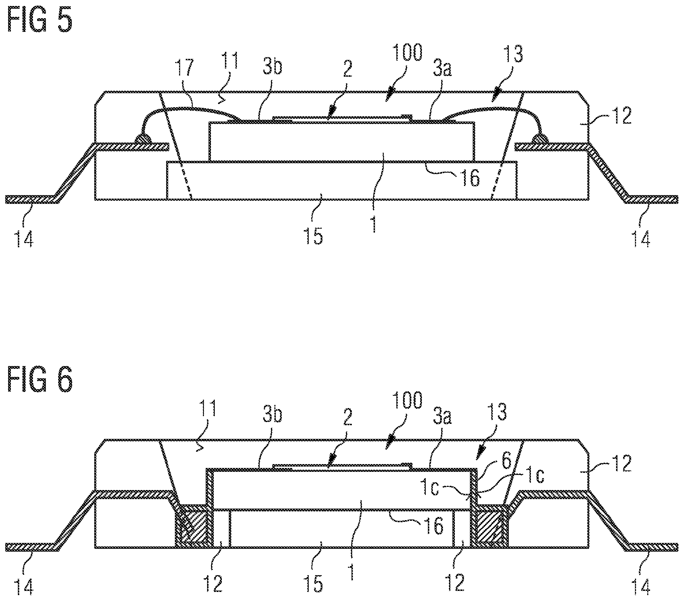

Anhand der schematischen Schnittdarstellungen der Figuren 5 und 6 sind Ausführungsbeispiele eines hier beschriebenen Bauteils näher erläutert.

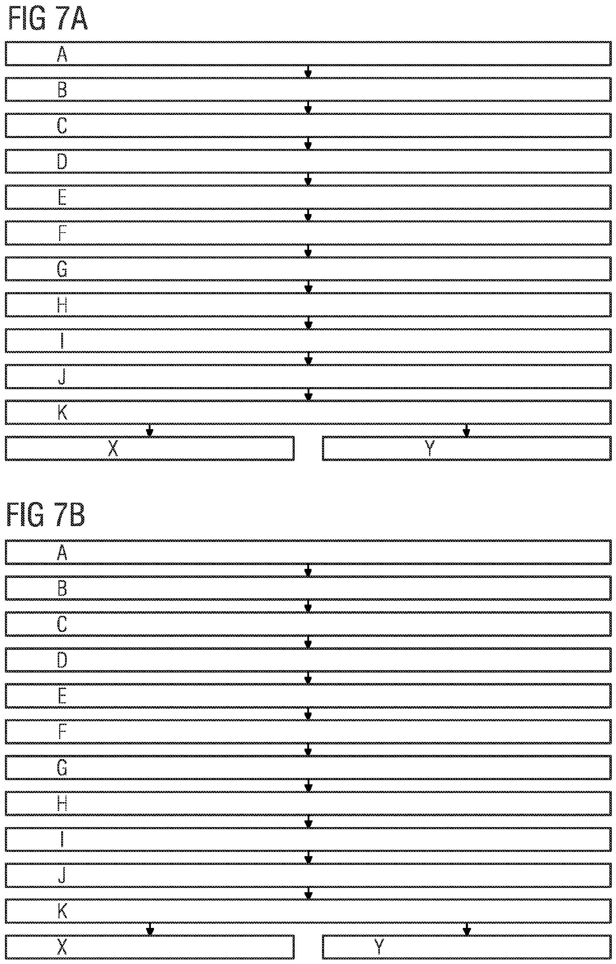

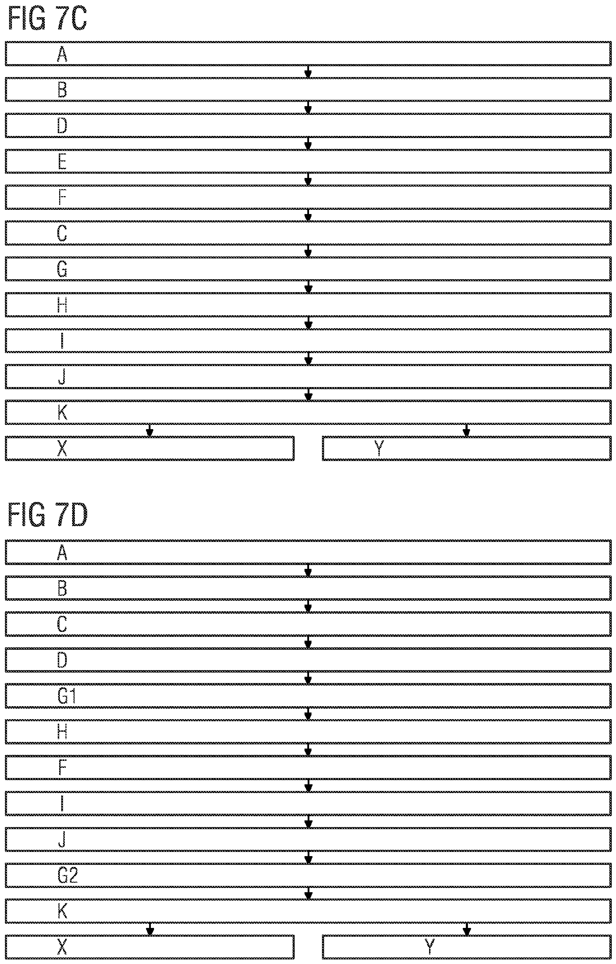

Anhand der Figuren 7A, 7B, 7C, 7D sind Prozessabläufe zur Herstellung eines optoelektronischen Bauelements gemäß einem hier beschriebenen Verfahren näher erläutert.

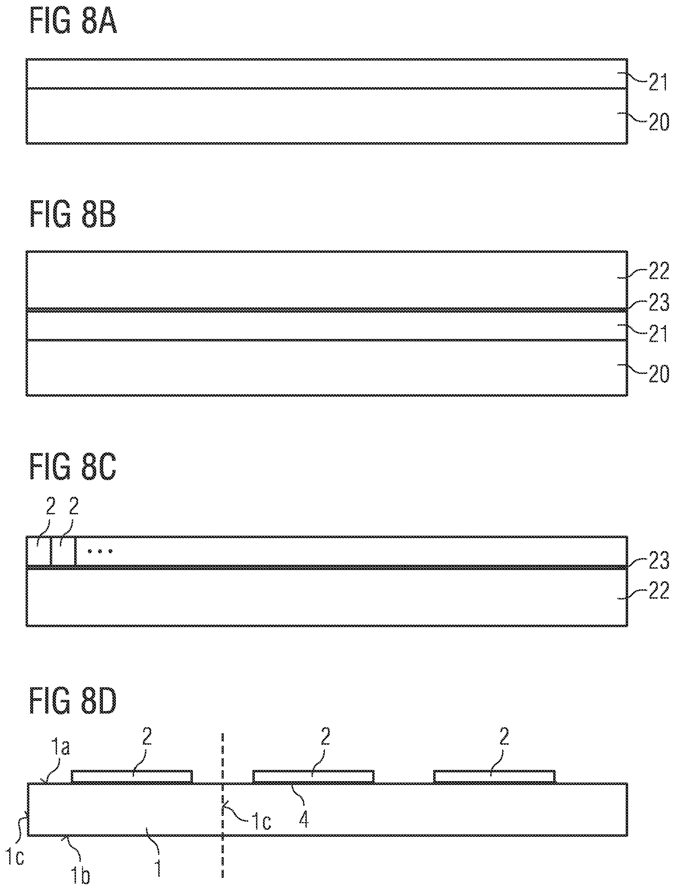

Anhand der Figuren 8A, 8B, 8C, 8D sind in schematischen Schnittdarstellungen Verfahrensschritte zur Herstellung eines hier beschriebenen optoelektronischen Bauelements näher erläutert.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Die Figur 1 zeigt ein Beispiel eines hier beschriebenen optoelektronischen Bauelements in einer schematischen Perspektivdarstellung. Das optoelektronische Bauelement 100 umfasst einen Träger 1. Der Träger 1 ist vorliegend in Form eines Quaders ausgebildet. Der Träger 1 ist beispielsweise ein Vollkörper, der aus einem Kunststoff, einem Silizium oder einem keramischen Material gebildet ist. Der Träger 1 umfasst eine erste Hauptfläche 1a und eine gegenüberliegende zweite Hauptfläche 1b. Ferner umfasst der Träger 1 Seitenflächen 1c, welche die erste Hauptfläche 1a und die zweite Hauptfläche 1b miteinander verbinden.

Das optoelektronische Bauelement 100 umfasst ferner einen substratlosen optoelektronischen Halbleiterchip 2. Vorliegend handelt es sich beim Halbleiterchip 2 um eine substratlose Leuchtdiode. Die substratlose Leuchtdiode 2 ist mittels eines Verbindungsmaterials 4, insbesondere mittels eines Lotmaterials, an der ersten Hauptfläche 1a auf dem Träger 1 befestigt. Mit seiner dem Träger 1 zugewandten Seite ist der Halbleiterchip 2 elektrisch leitend mit der Kontaktmetallisierung 3b verbunden. An seiner dem Träger 1 abgewandten Seite ist der Halbleiterchip 2 mit der Kontaktmetallisierung 3a elektrisch leitend verbunden. Der Halbleiterchip 2 umfasst beispielsweise einen elektrisch leitenden Kontaktrahmen 2a, der eine Strahlungsdurchtrittsfläche 2b des Halbleiterchips 2 seitlich umgibt. Die Kontaktmetallisierung 3a ist mit diesem Kontaktrahmen 2a elektrisch leitend verbunden.

Die Kontaktmetallisierungen 3a, 3b sind auf die erste Hauptfläche 1a des Trägers aufgebracht. Beispielsweise werden die Kontaktmetallisierungen 3a, 3b zu ihrer Herstellung großflächig auf die erste Hauptfläche 1a des Trägers aufgebracht, zum Beispiel aufgedampft und anschließend fhotolithographisch strukturiert.

Das optoelektronische Bauelement 100 umfasst ferner Öffnungen 5, die den Träger 1 von der ersten Hauptfläche 1a zur zweiten Hauptfläche 1b durchdringen. Vorliegend sind die Öffnungen 5 in Form von Zylindern ausgebildet. Pro Kontaktmetallisierung 3a, 3b ist eine Öffnung 5 vorhanden. In die Öffnungen 5 ist jeweils ein elektrisch leitendes Material 6, zum Beispiel ein Metall, eingebracht, das eine elektrisch leitende Verbindung zwischen den Kontaktmetallisierungen 3a, 3b und Bauelementanschlüssen 8, die an der zweiten Hauptfläche 1b des Trägers 1 ausgebildet sind, vermittelt. Die Öffnungen 5 können dabei vollständig mit dem elektrisch leitenden Material 6 befüllt sein. Ferner ist es möglich, dass lediglich die dem Träger 1 zugewandten Innenflächen der Öffnungen 5 mit dem elektrisch leitenden Material 6, zum Beispiel einem Metall, beschichtet sind.

Insgesamt ist auf diese Weise ein optoelektronisches Bauelement 100 angegeben, das oberflächenmontierbar ist. Das optoelektronische Bauelement kann zur Herstellung eines optoelektronischen Bauteils in einen Gehäusegrundkörper montiert werden (vergleiche dazu beispielsweise die Figuren 5 und 6). Ferner ist es möglich, dass das optoelektronische Bauelement selbst nach Art eines optoelektronischen Bauteils benutzt wird und keine weitere Häusung oder Verkapselung des Bauelements 100 erfolgt.

In Verbindung mit der Figur 2 ist ein weiteres Beispiel eines hier beschriebenen optoelektronischen Bauelements 100 näher erläutert. Im Unterschied zum Beispiel der Figur 1 wird der Träger entlang der Schnittlinien 7 durchtrennt. Das heißt, beispielsweise beim Vereinzeln eines Trägerverbunds wird durch die Öffnungen 5 hindurch vereinzelt, so dass elektrisch leitendes Material 6 in den Öffnungen 5 von einer Seitenfläche 1c des Trägers 1 her frei zugänglich ist. Auf diese Weise sind die durch die Öffnungen 5 gebildeten Durchkontaktierungen benetzbar. Es bildet sich bei der Lotmontage des optoelektronischen Bauelements 100 ein Lotmeniskus aus, der sich im Bereich des elektrisch leitenden Materials 6 in den Öffnungen 5 an der Seitenfläche 1c des Trägers 1 erstrecken kann. Dies dient einerseits zu einer verbesserten Kontaktierung des optoelektronischen Bauelements 100, andererseits ist auf diese Weise optisch kontrollierbar, ob eine zuverlässige Lotverbindung des Bauelements vorliegt, da davon ausgegangen werden kann, dass wenn eine Benetzung an den Seitenflächen vorliegt, auch die Bauelementanschlüsse 8 mit dem Lotmaterial benetzt sind.

In Verbindung mit der Figur 3 ist ein weiteres Beispiel eines hier beschriebenen optoelektronischen Bauelements 100 näher erläutert, bei dem im Unterschied zum Bauelement der Figur 1 ein Vergusskörper 11 vorhanden ist, der sich in direktem Kontakt mit dem Halbleiterchip 2 und dem Träger 1 an dessen erster Hauptfläche 1a befindet. Der Vergusskörper 11 kann beispielsweise aufgebracht werden, wenn der Träger 1 noch in einem Trägerverbund vorliegt. Bei der Vereinzelung des Trägerverbundes zu einzelnen Trägern 1 wird dann auch der Vergusskörper mit vereinzelt. Auf diese Weise schließen Seitenflächen 11c des Vergusskörpers 11 und Seitenflächen 1c des Trägers 1 bündig miteinander ab. Beide Seitenflächen 1c, 11c weisen dann Spuren des Vereinzelungsprozesses, zum Beispiel Bruchspuren oder Sägerillen auf.

Der Vergusskörper 11 kann ferner einen Bereich aufweisen, der als Linse 11a ausgebildet ist und beispielsweise zur Strahlformung dient oder die Wahrscheinlichkeit für einen Strahlungsaustritt aus dem optoelektronischen Bauelement 100 vergrößert. Der Vergusskörper ist zum Beispiel mit einem Silikon gebildet und kann diffus streuende Partikel und/oder Partikel eines Lumineszenzkonversionsmaterials (jeweils nicht dargestellt) enthalten.

In Verbindung mit der Figur 4 ist ein Ausführungsbeispiel eines hier beschriebenen optoelektronischen Bauelements näher erläutert. In diesem Ausführungsbeispiel umfasst das optoelektronische Bauelement 100 eine Mehrzahl, vorliegend fünf, substratlose optoelektronische Halbleiterchips 2. Jeder der optoelektronischen Halbleiterchips 2 ist über ein Paar von Kontaktmetallisierungen 3a, 3b elektrisch leitend verbindbar. Ferner ist es auch möglich, dass die optoelektronischen Halbleiterchips 2 in Reihe geschaltet sind. Es ist weiter auch möglich, dass Öffnungen 5 zur Bildung von Durchkontaktierungen vorhanden sind, über die die optoelektronischen Halbleiterchips 2 von der zweiten Hauptfläche 1b her über Bauelementanschlüsse 8 elektrisch kontaktierbar sind.

Vorliegend handelt es sich bei den optoelektronischen Halbleiterchips 2 um gleichartige substratlose Leuchtdioden. Die Halbleiterchips 2 werden nach einer Funktionsüberprüfung gezielt auf den Träger 1 aufgebracht. Es werden dabei solche Halbleiterchips 2 auf denselben Träger 1 aufgebracht, die so gut in ihren physikalischen Eigenschaften wie Peakwellenlänge des emittierten Lichts und Intensität des emittierten Lichts übereinstimmen, dass sie mit einer gemeinsamen Konverterschicht 9 belegt werden können. Das Bauelement 100 weist dann eine Abstrahlfläche auf, die durch die dem Träger 1 abgewandte Seite des Konversionselements 9 gebildet ist, von der Licht homogen abgestrahlt wird. Bei dem Konversionselement kann es sich beispielsweise um ein Matrixmaterial oder eine Folie handeln, in welche Partikel eines Lumineszenzkonversionsmaterials eingebracht sind. Darüber hinaus ist es möglich, dass das Konversionselement 9 durch ein Plättchen gebildet ist, das aus einem keramischen Lumineszenzkonversionsmaterial besteht. Das Konversionselement 9 überdeckt dabei auch Zwischenräume 10 zwischen benachbarten Halbleiterchips 2.

In Verbindung mit der schematischen Schnittdarstellung der Figur 5 ist ein erstes Ausführungsbeispiel eines hier beschriebenen optoelektronischen Bauteils näher erläutert. Das optoelektronische Bauteil umfasst einen Gehäusegrundkörper 12. Der Gehäusegrundkörper 12 ist beispielsweise mit einem Kunststoffmaterial oder einem keramischen Material gebildet. Der Gehäusegrundkörper 12 weist eine Kavität 3 auf, die zur Aufnahme eines hier beschriebenen optoelektronischen Bauelements 100 vorgesehen ist. Das optoelektronische Bauelement 100 wird vorliegend auf eine potenzialfreie Wärmesenke 15 aufgebracht, die einen geringen thermischen Widerstand aufweist. Die Anforderungen an die Oberflächenqualität der Wärmesenke 15 sind dabei gering, da die Wärmespreizung über die relativ große zweite Hauptfläche 1b des Trägers 1 gut ist und eine Montage mittels eines Klebstoffes 16 erlaubt. Das heißt, der Träger 1 dient zur Wärmespreizung der vom Halbleiterchip 2 im Betrieb erzeugten Wärme und wird über die zweite Hauptfläche 1b besonders großflächig an die Wärmesenke 15 abgegeben, so dass die thermische Anbindung zwischen Wärmesenke 15 und Träger 1 nicht besonders gut sein muss. Statt beispielsweise einer Lotmontage kann der Träger 1 daher auch auf die Wärmesenke 15 geklebt werden. Das Bauteil umfasst ferner Anschlussstellen 14, über die das Bauteil von außen kontaktiert werden kann. Die Anschlussstellen 14 sind mittels Bonddrähte 17 mit den Kontaktmetallisierungen 3a, 3b an der ersten Hauptfläche 1a des Trägers elektrisch leitend verbunden. Das optoelektronische Bauelement, das heißt, Träger und Halbleiterchip 2, kann mittels eines Vergusskörpers 11 vergossen sein, der auch in direktem Kontakt mit dem Gehäusegrundkörper 12 und der Wärmesenke 15 steht. Das optoelektronische Bauelement 100 kann also nach Art eines herkömmlichen optoelektronischen Halbleiterchips in der Kavität 13 des Gehäusegrundkörpers vergossen sein.

In Verbindung mit der schematischen Schnittdarstellung der Figur 6 ist ein weiteres Ausführungsbeispiel eines hier beschriebenen optoelektronischen Bauteils näher erläutert. Im Unterschied zum Ausführungsbeispiel der Figur 5 entfallen hier die Bonddrähte 17. Die Kontaktierung zwischen dem Halbleiterchip 2 und den Anschlussstellen 14 des Bauteils erfolgt beispielsweise über Durchkontaktierungen, wie sie in Verbindung mit den Figuren 1 und 2 näher beschrieben sind. Vorliegend liegt das elektrisch leitende Material 6 der Durchkontaktierungen an den Seitenflächen 1c des Trägers 1 frei, wie dies beispielsweise in Verbindung mit der Figur 2 näher erläutert ist. Insgesamt ist auf diese Weise im Vergleich zur Drahtkontaktierung der Figur 5 eine besonders flache und zuverlässige Bauform realisiert.

In Verbindung mit den Ablaufdiagrammen der Figuren 7A, 7B, 7C, 7D sind verschiedene Varianten von Prozessabläufen zur Herstellung eines hier beschriebenen optoelektronischen Bauelements näher erläutert. In Verbindung mit den Figuren 8A, 8B, 8C, 8D sind anhand schematischer Schnittdarstellungen einzelne Verfahrensschritte des hier beschrienen Verfahrens schematisch dargestellt.

Gemäß dem Prozessablauf, wie er in der Figur 7A beschrieben ist, weist das Verfahren die folgenden Schritte auf:
A: Zunächst wird eine aktive Schichtenfolge 21 auf einem Substrat 20 bereitgestellt (siehe dazu auch die Figur 8A). Bei der aktiven Schichtenfolge 21 handelt es sich beispielsweise um eine epitaktisch hergestellte aktive Schichtenfolge, die zur Detektion oder zur Erzeugung von elektromagnetischer Strahlung zumindest eine aktive Schicht aufweist. Die aktive Schichtenfolge 21 wird epitaktisch beispielsweise auf ein Aufwachssubstrat 20 abgeschieden.
B: In einem nachfolgenden Verfahrensschritt kann auf der dem Substrat 20 abgewandten Seite der aktiven Schichtenfolge 21 eine reflektierende Schicht hergestellt werden, die als Spiegel dient. Ferner können Passivierungen erzeugt werden, die beispielsweise zur Definition von Kontaktstellen der späteren Halbleiterchips 2 dienen.
C: Die aktive Schichtenfolge 21 kann nun in Einzelsegmente vereinzelt werden, welche später die Halbleiterchips 2 darstellen.
D: Nachfolgend kann auf die dem Substrat 20 abgewandte Seite der aktiven Schichtenfolge 21 eine Lotschicht aufgebracht werden.
E: In einem nachfolgenden Verfahrensschritt erfolgt die Übertragung der Einzelsegmente, das heißt der Chips, auf einen Hilfsträger 22, beispielsweise mittels eines Verbindungsmaterials 23, siehe dazu auch die Figur 8B. Nachfolgend wird das Substrat 20 von der aktiven Schichtenfolge 21 abgelöst, vergleiche dazu die Figur 8C.
F: Auf der Seite der aktiven Schichtenfolge 21, von der das Substrat 20 entfernt ist, werden Oberseitenkontakte des Halbleiterchips 2 hergestellt.
G: In diesem Schritt folgt die Funktionskontrolle der optoelektronischen Halbleiterchips. Vorliegend erfolgt die Funktionskontrolle auf dem Hilfsträger 22. Bei der Funktionskontrolle findet eine elektrisch-optische Charakterisierung der Halbleiterchips 2 statt, so dass diese nachfolgend entsprechend ihren physikalischen Eigenschaften sortiert werden können. Das heißt, es findet ein Wafer-Mapping statt, bei dem die einzelnen Halbleiterchips 2 in einzelne Klassen (so genannte Bins) eingeteilt werden.
H: Im nächsten Verfahrensschritt findet die Montage der Halbleiterchips 2 auf einem Trägerverbund mit einer Vielzahl von Trägern 1 statt, vergleiche auch die Figur 8D.
I: Nachfolgend werden die Oberseitenkontakte der Halbleiterchips 2 beispielsweise durch Metallisierungen und nachfolgende Fototechnik kontaktiert.
J: Gegebenenfalls erfolgt nun die Auftragung eines Konversionselements 9 und/oder der Verguss mit einem Vergusskörper 11.
K: Der Trägerverbund mit einer Vielzahl von Trägern 1 wird entlang der Seitenflächen 1c der Träger 1 zu einzelnen optoelektronischen Bauelementen 100 vereinzelt. Es entsteht ein fertiges oberflächenmontierbares Bauteil, wie es beispielsweise in Verbindung mit den Figuren 1, 2, 3 und 4 dargestellt ist (Schritt X) oder es erfolgt eine Montage des Bauelements in einen Gehäusegrundkörper, wie dies beispielsweise in Verbindung mit den Figuren 5 und 6 gezeigt ist (Schritt Y).

In Verbindung mit der Figur 7B ist ein alternativer Prozessablauf beschrieben. Im Unterschied zum in Verbindung mit der Figur 7A beschriebenen Prozessablauf sind dort die Prozessschritte D und C vertauscht. Das heißt, die Lotschicht wird vor einer Vereinzelung der aktiven Schichtenfolge 21 in Einzelsegmente aufgebracht.

In Verbindung mit der Figur 7C ist eine weitere Variante eines Prozessverlaufs für ein hier beschriebenes Herstellungsverfahren näher erläutert. Im Unterschied zum in Verbindung mit der Figur 7B beschriebenen Prozessablauf erfolgt die Vereinzelung der aktiven Schichtenfolge 21 in Einzelsegmente im Prozessschritt C hier nach dem Prozessschritt F, das heißt nach der Herstellung von Oberseitenkontakten. Mittels der Oberseitenkontakte kann in diesem Fall also die Position der späteren Halbleiterchips 2 definiert werden.

In Verbindung mit der Figur 7D ist eine weitere Variante eines hier beschriebenen Herstellungsverfahrens näher erläutert. Der in Verbindung mit der Figur 7D beschriebene Prozessablauf beschreibt ein Verfahren, bei dem auf einen Hilfsträger 22 verzichtet wird. Das heißt, der Verfahrensschritt E entfällt. Nach dem Verfahrensschritt D (Aufbringen der Lotschicht) erfolgt eine elektrisch-optische Charakterisierung der lichtaktiven Elemente, die noch auf das Substrat 20 aufgebracht sind (Verfahrensschritt G1). Im Verfahrensschritt H werden die lichtaktiven Elemente, also die späteren Halbleiterchips 2, auf dem Trägerverbund mit einer Vielzahl von Trägern 1 durch Abspalten vom Substrat 20 montiert.

Im Verfahrensschritt G2, der zum Beispiel nach dem Aufbringen eines Konversionselements 9 oder eines Vergusselements 11 im Verfahrensschritt J durchgeführt werden kann, erfolgt eine weitere elektrisch-optische Charakterisierung der bereits auf den Träger 1 montierten Halbleiterchips 2, bevor der Trägerverbund mit einer Vielzahl von Trägern 1 in einzelne optoelektronische Bauelemente 100 vereinzelt wird.

In Verbindung mit der Figur 9 ist anhand einer schematischen Schnittdarstellung ein weiteres Ausführungsbeispiel eines hier beschriebenen optoelektronischen Bauelements 100 näher erläutert. Im Unterschied zum in Verbindung mit der Figur 1 beschriebenen Beispiel ist der optoelektronische Halbleiterchip 2 im Ausführungsbeispiel der Figur 9 als oberflächenmontierbarer Halbleiterchip mit interner Kontaktverteilung ausgebildet. Das heißt, der Chip 2 umfasst Durchkontaktierungen 2c durch die der Halbleiterchip n-seitig kontaktiert ist. Die Durchkontaktierungen 2c durchdringen dabei die p-dotierten Schichten sowie die aktive Zone des Halbleiterchips 2. Genauso ist es jedoch denkbar, dass die Durchkontaktierungen 2c die p-Seite des Halbleiterchips 2 kontaktieren. Die Durchkontaktierungen 2c durchdringen dann die n-dotierten Bereiche sowie die aktive Zone des Halbleiterchips 2. Im Übrigen kann das optoelektronische Bauelement 100 der Figur 9 wie in Verbindung mit einer der Figuren 1, 2, 3 oder 4 beschrieben ausgebildet sein. Der Unterschied besteht dann lediglich in der Verwendung eines oberflächenmontierbaren Halbleiterchips.

Die Erfindung ist nicht durch die Beschreibung anhand der Ausführungsbeispiele auf diese beschränkt. Der Schutzbereich wird durch die Ansprüche definiert.

## Patentansprüche

1. Optoelektronisches Bauelement mit
- einem Träger (1), der eine erste Hauptfläche (la) aufweist,
- zumindest zwei vorsortierten, gleichartigen substratlosen optoelektronischen Halbleiterchips (2), die an der ersten Hauptfläche (la) des Trägers (1) befestigt sind, wobei gleichartige optoelektronische Halbleiterchips bei gleicher Bestromung innerhalb einer Toleranz von höchstens 10 % elektromagnetische Strahlung gleicher Intensität und der gleichen Wellenlänge emittieren,
- zumindest einem Konversionselement (9), das die gleichartigen optoelektronischen Halbleiterchips (2) an ihrer der ersten Hauptfläche (la) abgewandten Seite überdeckt, und
- einer Kontaktmetallisierung (3a, 3b), wobei
- der Träger (1) elektrisch isolierend ist,
- der Träger (1) zumindest eine Öffnung (5) aufweist, die sich von der ersten Hauptfläche (la) durch den Träger (1) hindurch zu einer gegenüberliegenden zweiten Hauptfläche (1b) erstreckt, wobei
- die Öffnung (5) zumindest stellenweise mit einem elektrisch leitenden Material (6) befüllt ist,
- das elektrisch leitende Material (6) elektrisch leitend mit der Kontaktmetallisierung (3a, 3b) verbunden ist, und
- das elektrisch leitende Material (6) zumindest einer Öffnung (5) in lateraler Richtung frei vom Träger (1) ist,
- die optoelektronischen Halbleiterchips (2) mittels eines Verbindungsmaterials (4), insbesondere eines Lotmaterials, an der ersten Hauptfläche (1a) des Trägers (1) befestigt sind,
- die Kontaktmetallisierung (3a, 3b) zumindest einen Bereich der ersten Hauptfläche (1a) bedeckt, der frei von den optoelektronischen Halbleiterchips (2) ist,
- die Kontaktmetallisierung (3a, 3b) elektrisch leitend mit den optoelektronischen Halbleiterchips (2) verbunden ist, und
- die zumindest zwei optoelektronischen Halbleiterchips (2) oberflächenmontierbare Halbleiterchips (2) sind, die Durchkontaktierungen (2c) aufweisen, wobei die Durchkontaktierungen (2c) p-dotierte Schichten und eine aktive Zone durchdringen und die Halbleiterchips n-seitig durch die Durchkontaktierungen (2c) kontaktiert sind oder die Durchkontaktierungen (2c) n-dotierte Schichten und die aktive Zone durchdringen und die Halbleiterchips p-seitig durch die Durchkontaktierungen (2c) kontaktiert sind.

2. Optoelektronisches Bauelement nach dem vorherigen Anspruch, bei dem
- zumindest eine Öffnung (5) in lateraler Richtung vollständig vom Träger (1) umgeben ist.

3. Optoelektronisches Bauelement nach einem der vorherigen Ansprüche, bei dem
- an der zweiten Hauptfläche (1b) des Trägers (1) zumindest ein Bauelementanschluss (8) angeordnet ist, wobei
- der Bauelementanschluss (8) elektrisch leitend mit dem elektrisch leitenden Material (6) zumindest einer Öffnung (5) verbunden ist.

4. Optoelektronisches Bauelement nach einem der vorherigen Ansprüche, bei dem
- das Konversionselement (9) einen Zwischenraum (10) zwischen zwei benachbarten gleichartigen optoelektronischen Halbleiterchips (2) überdeckt, wobei
ein reflektierendes Vergussmaterial die optoelektronischen Halbleiterchips in einer lateralen Richtung ringsum umgibt, und das reflektierende Vergussmaterial die erste Hauptfläche des Trägers vollständig bedeckt, wobei lediglich die dem Träger abgewandte Oberseite des optoelektronischen Halbleiterchips frei vom reflektierenden Vergussmaterial ist.

5. Optoelektronisches Bauelement nach einem der vorherigen Ansprüche mit
- einem Vergusskörper (11), der die optoelektronischen Halbleiterchips (2) zumindest stellenweise umformt, wobei
- der Vergusskörper (11) an die erste Hauptfläche (la) des Trägers (1) grenzt und
- zumindest eine Seitenfläche (11c) des Vergusskörpers bündig mit zumindest einer Seitenfläche (1c) des Trägers (1) abschließt.

6. Optoelektronisches Bauteil mit
- einem Gehäusegrundkörper (12) und
- zumindest einem optoelektronischen Bauelement (100) nach einem der vorherigen Ansprüche, wobei
- das optoelektronischen Bauelement (100) im oder am Gehäusegrundkörper (12) befestigt ist.

7. Optoelektronisches Bauteil nach dem vorherigen Anspruch, bei dem
- das optoelektronische Bauelement (100) zumindest stellenweise von einem Vergusskörper (11) umformt ist, wobei
- der Vergusskörper (11) an den Träger (1), die optoelektronischen Halbleiterchips (2) und den Gehäusegrundkörper (12) grenzt.

## Claims

1. Optoelectronic component comprising
- a carrier (1), having a first main area (1a),
- at least two presorted, substrateless optoelectronic semiconductor chips (2) of identical type which are fixed to the first main area (1a) of the carrier (1), wherein optoelectronic semiconductor chips of identical type emit electromagnetic radiation having the same intensity and the same wavelength with a tolerance of at most 10 % with the same energization,
- at least one conversion element (9) which covers the optoelectronic semiconductor chips (2) of identical type at their side remote from the first main area (1a), and
- a contact metallization (3a, 3b), wherein
- the carrier (1) is electrically insulated,
- the carrier (1) has at least one opening (5) extending from the first main area (1a) through the carrier (1) to an opposite second main area (1b), wherein
- the opening (5) is filled with an electrically conductive material (6) at least in places,
- the electrically conductive material (6) is electrically conductively connected to the contact metallization (3a, 3b), and
- the electrically conductive material (6) of at least one opening (5) is free of the carrier (1) in a lateral direction,
- the optoelectronic semiconductor chips (2) are fixed to the first main area (1a) of the carrier (1) by means of a connecting material (4), in particular a solder material,
- the contact metallization (3a, 3b) covers at least one region of the first main area (1a) which is free of the optoelectronic semiconductor chip (2),
- the contact metallization (3a, 3b) is electrically conductively connected to the optoelectronic semiconductor chips (2), and
- the at least two optoelectronic semiconductor chips (2) are surface-mountable semiconductor chips (2) which comprise plated-through holes (2c), wherein the plated-through holes (2c) penetrate through p-doped layers and an active zone and the semiconductor chips are contact-connected on the n-side by the plated-through holes (2c) or the plated-through holes (2c) penetrate through n-doped layers and the active zone and the semiconductor chips are contact-connected on the p-side by the plated-through holes (2c).

2. Optoelectronic component according to the preceding claim, wherein
- at least one opening (5) is surrounded completely by the carrier (1) in a lateral direction.

3. Optoelectronic component according to any of the preceding claims, wherein
- at least one component connection (8) is arranged at the second main area (1b) of the carrier (1), wherein
- the component connection (8) is electrically conductively connected to the electrically conductive material (6) in at least one opening (5).

4. Optoelectronic component according to any of the preceding claims, wherein
- the conversion element (9) covers an interspace (10) between two adjacent optoelectronic semiconductor chips (2) of identical type, wherein
- a reflective potting material surrounds the optoelectronic semiconductor chip all around in a lateral direction, and the reflective potting material completely covers the first main area of the carrier, wherein only the top side of the optoelectronic semiconductor chip facing away from the carrier is free of the reflective potting material.

5. Optoelectronic component according to any of the preceding claims, comprising
- a potting body (11), which molds around the optoelectronic semiconductor chips (2) at least in places, wherein
- the potting body (11) adjoins the first main area (1a) of the carrier (1), and
- at least one side area (11c) of the potting body terminates flush with at least one side area (1c) of the carrier (1).

6. Optoelectronic device comprising
- a housing base body (12), and
- at least one optoelectronic component (100) according to any of the preceding claims, wherein
- the optoelectronic component (100) is fixed in or to the housing base body (12).

7. Optoelectronic device according to the preceding claim, wherein
- a potting body (11) is molded around the optoelectronic component (100) at least in places, wherein
- the potting body (11) adjoins the carrier (1), the optoelectronic semiconductor chips (2) and the housing base body (12).

## Revendications

1. Composant optoélectronique comportant
- un support (1) présentant une première surface principale (1a),
- au moins deux puces semi-conductrices optoélectroniques (2) similaires, sans substrat, pré-triées, fixées à la première surface principale (la) du support (1), les puces semi-conductrices optoélectroniques similaires émettant un rayonnement électromagnétique de même intensité et de même longueur d'onde au sein d'une tolérance maximale de 10 % avec le même courant,
- au moins un élément convertisseur (9) recouvrant les puces semi-conductrices optoélectroniques similaires (2) sur leur face opposée à la première surface principale (1a), et
- une métallisation de contact (3a, 3b), dans laquelle
- le support (1) est électro-isolant,
- le support (1) présente au moins un orifice (5) s'étendant à travers le support (1) de la première surface principale (la) jusqu'à une seconde surface principale opposée (1b), dans laquelle
- l'orifice (5) est au moins partiellement rempli d'un matériau conducteur d'électricité (6),
- le matériau conducteur d'électricité (6) est raccordé en tant que conducteur d'électricité à la métallisation de contact (3a, 3b) et
- le matériau conducteur d'électricité (6) d'au moins un orifice (5) est exempt du support (1) en direction latérale,
- les puces semi-conductrices optoélectroniques (2) sont fixées à la première surface principale (la) du support (1) au moyen d'un matériau de connexion (4), en particulier un matériau de brasure,
- la métallisation de contact (3a, 3b) couvre au moins une zone de la première surface principale (la) qui est exempte des puces semi-conductrices optoélectroniques (2),
- la métallisation de contact (3a, 3b) est raccordée en tant que conductrice d'électricité aux puces semi-conductrices optoélectroniques (2), et
- les puces semi-conductrices optoélectroniques (2) présentes en deux exemplaires au moins sont des puces semi-conductrices (2) montables en surface équipées de contacts traversants (2c), les contacts traversants (2c) pénétrant des couches dopées p et une zone active et les puces semi-conductrices étant en contact côté n par les contacts traversants (2c) ou les contacts traversants (2c) pénétrant des couches dopées n et la zone active et les puces semi-conductrices étant en contact côté p par les contacts traversants (2c).

2. Composant optoélectronique selon la revendication précédente, dans lequel
- au moins un orifice (5) est complètement entouré par le support (1) dans le sens latéral.

3. Composant optoélectronique selon l'une des revendications précédentes, dans lequel
- au moins un connecteur de composant (8) est disposé sur la seconde surface principale (1b) du support (1),
- le connecteur de composant (8) étant raccordée en tant que conducteur d'électricité au matériau conducteur d'électricité (6) d'au moins un orifice (5).

4. Composant optoélectronique selon l'une des revendications précédentes, dans lequel
- l'élément convertisseur (9) recouvre un espace intermédiaire (10) entre deux puces semi-conductrices optoélectroniques similaires adjacentes (2), dans lequel
un matériau de scellement réfléchissant entoure totalement les puces semi-conductrices optoélectroniques dans une direction latérale et le matériau de scellement réfléchissant couvre complètement la première surface principale du support, seule la surface supérieure de la puce semi-conductrice optoélectronique tournée vers l'extérieur du support étant exempte du matériau de scellement réfléchissant.

5. Composant optoélectronique selon l'une des revendications précédentes comportant
- un corps de scellement (11) qui remodèle au moins localement les puces semi-conductrices optoélectroniques (2),
- le corps de scellement (11) étant adjacent à la première surface principale (la) du support (1) et
- au moins une face latérale (11c) du corps de scellement est alignée avec au moins une face latérale (1c) du support (1).

6. Élément optoélectronique comportant
- un corps de base du boîtier (12) et
- au moins un composant optoélectronique (100) selon l'une des revendications précédentes,
- le composant optoélectronique (100) étant fixé dans ou sur le corps de base du boîtier (12).

7. Composant optoélectronique selon la revendication précédente,
- le composant optoélectronique (100) étant remodelé au moins en partie par un corps de scellement (11),
- le corps de scellement (11) jouxtant le support (1), les puces semi-conductrices optoélectroniques (2) et le corps de base du boîtier (12).
